Europäisches Patentamt

European Patent Office

Office européen des brevets

(19)

(11) Veröffentlichungsnummer: **0 057 368**
**B1**

(12) # EUROPÄISCHE PATENTSCHRIFT

(45) Veröffentlichungstag der Patentschrift :
03.12.86

(21) Anmeldenummer : 82100330.8

(22) Anmeldetag : 19.01.82

(51) Int. Cl.⁴ : **G 01 D 18/00**

(54) Digitale elektrische Längen- oder Winkelmesseinrichtung.

(30) Priorität : 03.02.81 DE 3103485

(43) Veröffentlichungstag der Anmeldung :
11.08.82 Patentblatt 82/32

(45) Bekanntmachung des Hinweises auf die Patenterteilung : 03.12.86 Patentblatt 86/49

(84) Benannte Vertragsstaaten :
AT CH FR GB IT LI NL SE

(56) Entgegenhaltungen :
DE-A- 2 944 213
DE-A- 3 010 611

(73) Patentinhaber : Dr. Johannes Heidenhain GmbH
Nansenstrasse 17
D-8225 Traunreut (DE)

(72) Erfinder : Schmitt, Walter
Hochgernstrasse 22
D-8225 Traunreut (DE)

Jouve, 18, rue St-Denis, 75001 Paris, France

**Beschreibung**

Die Erfindung betrifft eine digitale elektrische Längen- oder Winkelmeßeinrichtung gemäß dem Oberbegriff des Anspruchs 1.

Gemäß EP-B1-36 976 (Veröffentlichungstag 07.10.81 ; Prioritätsdokument DE-A1-3010611 ; Prioritätsdatum 20.03.80) werden den Triggerstufen der Auswerteeinrichtung zur Überprüfung der Einstellung der Triggerschwellen positive (+) oder negative (—) Gleichspannungsprüfsignale zugeführt, wodurch eine Aussage über eine gute oder schlechte Einstellung der Triggerschwellen ermöglicht wird.

Speziell bei Codemeßeinrichtungen liefern die Codegeber in der Regel trapezförmige Abtastsignale, die zum Teil sehr steile Flanken aufweisen. Deshalb ist es nicht möglich, den Abgleich der Triggerschwellen der Triggerstufen in der Auswerteeinrichtung durch eine Tastverhältnismessung der Ausgangssignale der Triggerstufen zu beurteilen.

Es ist bekannt, in derartigen Fällen die Überprüfung des Abgleichs mittels eines Oszilloskops vorzunehmen.

Diese Art der Überprüfung ist umständlich und nicht sehr genau. Zudem ist dieses Prüfverfahren bei Codemeßeinrichtungen unbrauchbar, deren Codegeber zur Abfrage der absoluten Positionswerte nur kurzzeitig eingeschaltet werden.

Der Erfindung liegt die Aufgabe zugrunde, bei einer digitalen elektrischen Längen- oder Winkelmeßeinrichtung eine Prüfeinrichtung anzugeben, die neben der Überprüfung der Einstellung der Triggerschwellen der Triggerstufen zusätzlich eine Beurteilung der Beschaffenheit der Abtastsignale der Abtasteinheit erlaubt.

Diese Aufgabe wird erfindungsgemäß gelöst, wie im Patentanspruch 1 angegeben.

Die mit der Erfindung erzielten Vorteile bestehen insbesondere darin, daß die Beurteilung der Einstellung der Triggerschwellen der Triggerstufen und der Beschaffenheit der Abtastsignale der Abtasteinheit (Amplitude, Kontrast, Signalform, Störanteile etc.) mit einem Tastverhältnismeßgerät ähnlich wie bei einer inkrementalen Meßeinrichtung über die Ausgangssignale der Triggerstufen bzw. des Gebers, insbesondere ohne Öffnen desselben, ermöglicht wird.

Weitere vorteilhafte Ausbildungen der Erfindung entnimmt man den abhängigen Patentansprüchen.

Ausführungsbeispiele der Erfindung werden anhand der Zeichnung näher erläutert.

Es zeigen

Figur 1 schematisch eine absolute Winkelmeßeinrichtung und

Figur 2 eine Schaltungsanordnung nach der Erfindung.

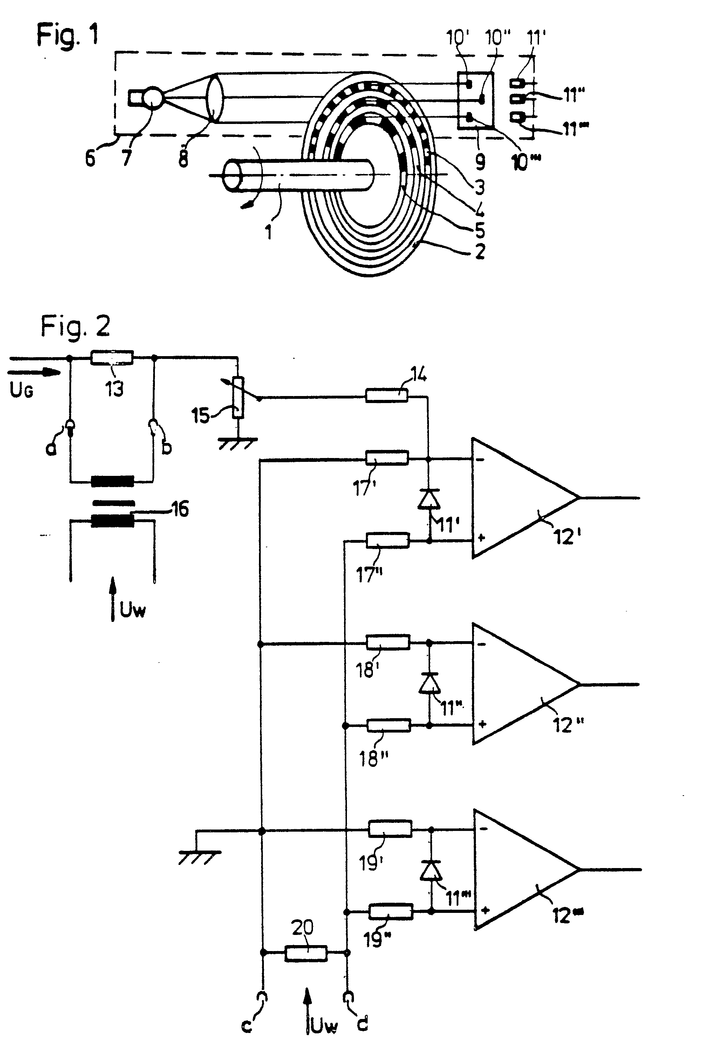

Die in Figur 1 dargestellte absolute Winkelmeßeinrichtung weist eine von einer Geberwelle 1 angetriebene Maßverkörperung 2 in Form einer transparenten Scheibe auf, auf der eine Meßteilung in Form einer Feinspur 3 und zweier Grobspuren 4, 5 konzentrisch angeordnet ist. Eine Abtasteinheit 6 weist eine Lampe 7, einen Kondensor 8, eine Abtastplatte 9 mit einem Abtastfeld 10' für die Feinspur 3 und Abtastfeldern 10", 10''' für die Grobspuren 4, 5 sowie den Abtastfeldern 10', 10", 10''' zugeordnete Photodioden 11', 11", 11''' auf.

Gemäß Figur 2 sind die Photodioden 11', 11", 11''' jeweils an die beiden Eingänge von Triggerstufen 12', 12", 12''' zur Auswertung ihrer Abtastsignale angeschlossen. Die Triggerschwelle beispielsweise der Triggerstufe 12' wird zur exakten Triggerung des Abtastsignals der Photodiode 11' mittels eines Gleichlichtsignals $U_G$ eingestellt, das über Widerstände 13, 14 und ein Potentiometer 15 dem invertierenden Eingang der Triggerstufe 12' zugeführt wird. Diesem Gleichlichtsignal $U_G$, das beispielsweise durch eine nicht dargestellte separate Photodiode gewonnen werden kann, wird über einen Transformator 16 und Steckanschlüsse a, b ein Prüfsignal $U_W$ in Form einer Wechselspannung überlagert.

Zur Überprüfung der Lage der Triggerschwelle der Triggerstufe 12' wird durch die Überlagerung des Gleichlichtsignals $U_G$ mit dem Prüfsignal $U_W$ die Triggerschwelle mit der Frequenz dieser Wechselspannung $U_W$ verschoben. Wählt man dabei die Amplitude des Prüfsignals $U_W$ so groß, daß die Triggerschwelle über den Amplitudenbereich des Abtastsignals der Photodiode 11' verschoben wird, so tritt ein periodisches Schalten der Triggerstufe 12' im Takt der Wechselspannung $U_W$ ein, wobei das Tastverhältnis des Ausgangssignals der Triggerstufe 12' vom Augenblickswert des Abtastsignals der Photodiode 11' und vom Gleichlichtsignal $U_G$ abhängig ist, was zu einer Modulierung des Tastverhältnisses des Ausgangssignales der Triggerstufe 12' führt.

Damit ist eine Beurteilung der Einstellung der Triggerschwelle der Triggerstufe 12' sowie der Beschaffenheit des Abtastsignals der Photodiode 11' (Amplitude, Kontrast, Signalform, Störanteil etc.) mit einem Tastverhältnismeßgerät über das Ausgangssignal der Triggerstufe 12' möglich.

In gleicher, nicht dargestellter Weise wird auch den Triggerstufen 12", 12''' ein Gleichlichtsignal zugeführt, dem ein Prüfsignal überlagert wird.

Wird das Prüfsignal $U_W$ über Steckanschlüsse c, d direkt den Triggerschwellen der Triggerstufen 12', 12", 12''' mit bekannter Amplitude zugeführt, so können die Amplituden der Abtastsignale gemessen sowie deren weitere Beschaffenheit beurteilt werden.

Mit den Bezugszeichen 17', 17", 18', 18" und 19', 19" sind Arbeitswiderstände und mit dem Bezugszeichen 20 ein Einkopplungswiderstand bezeichnet.

Vorzugsweise wird zur Zuführung des Prüfsignals $U_W$ ein Einspeisepunkt a, b bzw. c, d für alle den Photodioden 11', 11", 11''' zugeordneten Triggerstufen 12', 12", 12''' im Geber der absoluten Winkelmeßeinrichtung vorgeschlagen.

Werden diese Einspeisepunkte aus dem Geber herausgeführt, so kann derselbe ohne Öffnen extern überprüft werden. Diese Überprüfung kann manuell oder automatisch in bestimmten Zeitabständen mittels eines nicht gezeigten Rechners erfolgen.

Die Einkopplung des Prüfsignals $U_W$ über den Transformator 16 erfolgt bei kurzzeitig eingeschalteten Gebern, während bei ständig eingeschalteten Gebern diese Einkopplung über einen nicht gezeigten Kondensator vorgenommen wird.

Die Triggerschwellen der Triggerstufen können auch durch Abschattung der Meßteilung mittels Abgleichschrauben oder durch eine feste Gleichspannung eingestellt werden.

Die Frequenz des Prüfsignals $U_W$ muß so bemessen sein, daß mindestens eine Periode der Wechselspannung $U_W$ in einen Schritt des Gebers oder, bei kurzzeitig eingeschaltetem Geber, in eine Abtastzeit fällt.

Bei einer dreieckförmigen Signalform des Prüfsignals $U_W$ ergibt sich eine lineare Modulation der Tastverhältnisse der Ausgangssignale der Triggerstufen 12', 12'', 12'''. Da die Photodioden 11', 11'', 11''' gewisse Kapazitäten aufweisen, die im Zusammenwirken mit den Widerständen 14 ; 17', 17'' ; 18', 18'' ; 19', 19'' bestimmte Zeitkonstanten zur Folge haben, kann es zweckmäßig sein, je nach Zeitkonstante und Frequenz des Prüfsignals $U_W$ auch Prüfsignale $U_W$ mit sinusförmiger oder rechteckförmiger Signalform zu verwenden.

Die Erfindung ist nicht auf inkrementale oder absolute lichtelektrische Positionsmeßeinrichtungen beschränkt, sondern auch bei kapazitiven, induktiven und magnetischen Meßeinrichtungen mit Erfolg anwendbar.

## Patentansprüche

1. Digitale elektrische Längen- oder Winkelmeßeinrichtung mit einer Abtasteinheit (6) zur Abtastung einer Meßteilung, mit einer Auswerteeinrichtung mit Triggerstufen (12) zur Auswertung der von der Abtasteinheit (6) gelieferten Abtastsignale sowie mit einer Prüfeinrichtung zur Überprüfung der Einstellung der Triggerschwellen der Triggerstufen (12), indem den Triggerstufen (12) wenigstens ein von der Prüfeinrichtung erzeugtes Prüfsignal zugeführt ist, dadurch gekennzeichnet, daß die Prüfeinrichtung so ausgebildet ist, daß das Prüfsignal ($U_W$) von einer Wechselspannung gebildet ist.

2. Meßeinrichtung nach Anspruch 1, dadurch gekennzeichnet, daß die Parameter, d. h. Amplitude und Frequenz, des Prüfsignals ($U_W$) variabel sind.

3. Meßeinrichtung nach Anspruch 1 oder 2, dadurch gekennzeichnet, daß die Signalform des Prüfsignals ($U_W$) sinusförmig, dreieckförmig oder rechteckförmig ist.

4. Meßeinrichtung nach Anspruch 1, dadurch gekennzeichnet, daß die Triggerschwellen der Triggerstufen (12) durch ein Gleichlichtsignal ($U_G$) eingestellt sind.

5. Meßeinrichtung nach Anspruch 1, dadurch gekennzeichnet, daß die Triggerschwellen der Triggerstufen (12) durch Abgleichschrauben eingestellt sind.

6. Meßeinrichtung nach Anspruch 1, dadurch gekennzeichnet, daß die Triggerschwellen der Triggerstufen (12) durch eine feste Gleichspannung eingestellt sind.

7. Meßeinrichtung nach Anspruch 4, dadurch gekennzeichnet, daß das Gleichlichtsignal ($U_G$) von einem separaten lichtempfindlichen Element erzeugt ist.

8. Meßeinrichtung nach Anspruch 4, dadurch gekennzeichnet, daß das Prüfsignal ($U_W$) dem Gleichlichtsignal ($U_G$) überlagert ist.

9. Meßeinrichtung nach Anspruch 1, dadurch gekennzeichnet, daß das Prüfsignal ($U_W$) den Abtastsignalen der Photodioden (11) überlagert ist.

10. Meßeinrichtung nach Anspruch 1, dadurch gekennzeichnet, daß zur Zuführung des Prüfsignals ($U_W$) mindestens ein spezieller Einspeisepunkt (a, b ; c, d) vorgesehen ist.

11. Meßeinrichtung nach Anspruch 1, dadurch gekennzeichnet, daß ein Rechner vorgesehen ist, wobei die Überprüfung der Einstellung der Triggerschwellen der Triggerstufen (12) manuell oder automatisch in bestimmten Zeitabständen erfolgt.

## Claims

1. Digital electric length or angle measuring device comprising a scanning unit (6) for scanning a measuring graduation, including an evaluating device having trigger stages (12) for evaluating the scanning signals supplied by the scanning unit (6) and having a test device for checking the setting of the trigger thresholds of the trigger stages (12) by supplying the trigger stages (12) with at least one test signal generated by the test device, characterised in that the test device is constructed in such a manner that the test signal ($U_W$) is formed from an alternating voltage.

2. Measuring device according to Claim 1, characterised in that the parameters, that is to say amplitude and frequency, of the test signal ($U_W$) are variable.

3. Measuring device according to Claim 1 or 2, characterised in that the signal shape of the test signal ($U_W$) is sinusoidal, triangular or rectangular.

4. Measuring device according to Claim 1, characterised in that the trigger thresholds of the trigger stages (12) are set by a constant light signal ($U_G$).

5. Measuring device according to Claim 1, characterised in that the trigger thresholds of the trigger stages (12) are set by calibrating screws.

6. Measuring device according to Claim 1, characterised in that the trigger thresholds of the trigger stages (12) are set by a fixed direct voltage.

7. Measuring device according to Claim 4, characterised in that the constant light signal ($U_G$) is generated by a separate light-sensitive element.

8. Measuring device according to Claim 4, characterised in that the test signal ($U_W$) is superimposed on the constant light signal ($U_G$).

9. Measuring device according to Claim 1, characterised in that the test signal ($U_W$) is superimposed on the scanning signals of the photodiodes (11).

10. Measuring device according to Claim 1, characterised in that at least one special feeding-in point (a, b ; c, d) is provided for supplying the test signal ($U_W$).

11. Measuring device according to Claim 1, characterised in that a computer is provided, the setting of the trigger thresholds of the trigger stages (12) being manually or automatically checked at particular time intervals.

**Revendications**

1. Dispositif de mesure de longueurs ou d'angles numérique électrique, doté d'une unité exploratrice (6) pour exploration d'une graduation de mesure, d'un dispositif d'évaluation avec des étages déclencheurs (12) pour évaluation des signaux d'exploration délivrés par l'unité exploratrice (6) ainsi que d'un dispositif de contrôle pour contrôle du réglage des seuils de déclenchement des étages déclencheurs (12), au moins un signal de contrôle engendré par le dispositif de contrôle en question étant amené aux étages déclencheurs (12), caractérisé par le fait que le dispositif de contrôle est ainsi établi que le signal de contrôle ($U_W$) est formé par une tension alternative.

2. Dispositif de mesure selon la revendication 1 caractérisé par le fait que le dispositif est ainsi établi que les paramètres, c'est-à-dire l'amplitude et la fréquence, du signal de contrôle ($U_W$) sont variables.

3. Dispositif de mesure selon la revendication 1 ou 2 caractérisé par le fait que la forme du signal ($U_W$) est sinusoïdale, triangulaire ou rectangulaire.

4. Dispositif de mesure selon la revendication 1 caractérisé par le fait que les seuils de déclenchement des étages déclencheurs (12) sont réglés par un signal de lumière continue ($U_G$).

5. Dispositif de mesure selon la revendication 1 caractérisé par le fait que les seuils de déclenchement des étages déclencheurs (12) sont réglés par des vis de compensation.

6. Dispositif de mesure selon la revendication 1 caractérisé par le fait que les seuils de déclenchement des étages déclencheurs (12) sont réglés par une tension continue fixe.

7. Dispositif de mesure selon la revendication 4 caractérisé par le fait que le signal de lumière continue ($U_G$) est engendré par un élément photosensible séparé.

8. Dispositif de mesure selon la revendication 4 caractérisé par le fait que le signal de contrôle ($U_W$) est superposé au signal de lumière continue ($U_G$).

9. Dispositif de mesure selon la revendication 1 caractérisé par le fait que le signal de contrôle ($U_W$) est superposé aux signaux d'exploration des photodiodes (11).

10. Dispositif de mesure selon la revendication 1 caractérisé par le fait qu'il comporte au moins un point d'introduction spécial (a, b ; c, d) pour l'amenée du signal de contrôle ($U_W$).

11. Dispositif de mesure selon la revendication 1 caractérisé par le fait qu'il comporte un calculateur avec lequel le contrôle du réglage des seuils de déclenchement des étages déclencheurs (12) s'effectue manuellement ou automatiquement à des intervalles de temps déterminés.

# Fig. 1

# Fig. 2